(19) Europäisches Patentamt
European Patent Office
Office européen des brevets

(11) **EP 3 094 766 B1**

(12) **EUROPEAN PATENT SPECIFICATION**

(45) Date of publication and mention
of the grant of the patent:
**29.09.2021 Bulletin 2021/39**

(51) Int Cl.:
***C30B 7/10*** *(2006.01)*          ***C30B 29/40*** *(2006.01)*
***H01L 21/02*** *(2006.01)*

(21) Application number: **15702083.5**

(22) Date of filing: **16.01.2015**

(86) International application number:
**PCT/US2015/011793**

(87) International publication number:
**WO 2015/109211 (23.07.2015 Gazette 2015/29)**

(54) **GROUP III NITRIDE BULK CRYSTALS AND FABRICATION METHOD**

GRUPPE-III-NITRID-MASSENKRISTALLE UND HERSTELLUNGSVERFAHREN

CRISTAUX MASSIFS DE NITRURE D'ÉLÉMENT DU GROUPE III ET PROCÉDÉ DE FABRICATION CORRESPONDANT

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **17.01.2014   US 201461928883 P**

(43) Date of publication of application:
**23.11.2016   Bulletin 2016/47**

(73) Proprietors:
- **SixPoint Materials, Inc.**
  **Buellton, CA 93427 (US)**
- **Seoul Semiconductor Co., Ltd.**
  **Ansan-si, Gyeonggi-do 15429 (KR)**

(72) Inventors:
- **HASHIMOTO, Tadao**
  **Santa Barbara, California 93111 (US)**
- **LETTS, Edward**
  **Buellton, California 93427 (US)**

(74) Representative: **J A Kemp LLP**
**14 South Square**
**Gray's Inn**
**London WC1R 5JJ (GB)**

(56) References cited:
**WO-A1-2009/149299     WO-A1-2010/017232**
**WO-A1-2011/044554     WO-A1-2012/176318**

- **None**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

## CROSS REFERENCE TO RELATED APPLICATIONS

This application claims the benefit of priority to U.S. Application. No. 61/928,883 entitled "Group III Nitride Bulk Crystals and Their Fabrication Method" filed Jan. 17, 2014 and naming inventors Tadao Hashimoto and Edward Letts.
This application is also related to the following U.S. patent applications:

US Utility Patent Application Serial No. US2005/024239, filed on July 8, 2005, by Kenji Fujito, Tadao Hashimoto and Shuji Nakamura, entitled "METHOD FOR GROWING GROUP III-NITRIDE CRYSTALS IN SUPERCRITICAL AMMONIA USING AN AUTOCLAVE," attorneys' docket number 30794.0129-WO-01 (2005-339-1);

United States Utility Patent Application Serial No. 11/784,339, filed on April 6, 2007, by Tadao Hashimoto, Makoto Saito, and Shuji Nakamura, entitled "METHOD FOR GROWING LARGE SURFACE AREA GALLIUM NITRIDE CRYSTALS IN SUPERCRITICAL AMMONIA AND LARGE SURFACE AREA GALLIUM NITRIDE CRYSTALS," attorneys docket number 30794.179-US-U1 (2006-204), which application claims the benefit under 35 U.S.C. Section 119(e) of United States Provisional Patent Application Serial No. 60/790,310, filed on April 7, 2006, by Tadao Hashimoto, Makoto Saito, and Shuji Nakamura, entitled "A METHOD FOR GROWING LARGE SURFACE AREA GALLIUM NITRIDE CRYSTALS IN SUPERCRITICAL AMMONIA AND LARGE SURFACE AREA GALLIUM NITRIDE CRYSTALS," attorneys docket number 30794.179-US-P1 (2006-204);

United States Utility Patent Application Serial No. 60/973,602 , filed on September 19, 2007, by Tadao Hashimoto and Shuji Nakamura, entitled "GALLIUM NITRIDE BULK CRYSTALS AND THEIR GROWTH METHOD," attorneys docket number 30794.244-US-P1 (2007-809-1);

United States Utility Patent Application Serial No. 11/977,661, filed on October 25, 2007, by Tadao Hashimoto, entitled "METHOD FOR GROWING GROUP III-NITRIDE CRYSTALS IN A MIXTURE OF SUPERCRITICAL AMMONIA AND NITROGEN, AND GROUP III-NITRIDE CRYSTALS GROWN THEREBY," attorneys docket number 30794.253-US-U1 (2007-774-2);

United States Utility Patent Application Serial No. 61/067,117, filed on February 25, 2008, by Tadao Hashimoto, Edward Letts, Masanori Ikari, entitled "METHOD FOR PRODUCING GROUP III-NITRIDE WAFERS AND GROUP III-NITRIDE WAFERS," attorneys docket number 62158-30002.00 or SIXPOI-003;

United States Utility Patent Application Serial No. 61/058,900, filed on June 4, 2008, by Edward Letts, Tadao Hashimoto, Masanori Ikari, entitled "METHODS FOR PRODUCING IMPROVED CRYSTALLINITY GROUP III-NITRIDE CRYSTALS FROM INITIAL GROUP III-NITRIDE SEED BY AMMONOTHERMAL GROWTH," attorneys docket number 62158-30004.00 or SIXPOI-002;

United States Utility Patent Application Serial No. 61/058,910, filed on June 4, 2008, by Tadao Hashimoto, Edward Letts, Masanori Ikari, entitled "HIGH-PRESSURE VESSEL FOR GROWING GROUP III NITRIDE CRYSTALS AND METHOD OF GROWING GROUP III NITRIDE CRYSTALS USING HIGH-PRESSURE VESSEL AND GROUP III NITRIDE CRYSTAL," attorneys docket number 62158-30005.00 or SIXPOI-005;

United States Utility Patent Application Serial No. 61/131,917, filed on June 12, 2008, by Tadao Hashimoto, Masanori Ikari, Edward Letts, entitled "METHOD FOR TESTING III-NITRIDE WAFERS AND III-NITRIDE WAFERS WITH TEST DATA," attorneys docket number 62158-30006.00 or SIXPOI-001;

United States Utility Patent Application Serial No. 61/106,110, filed on October 16, 2008, by Tadao Hashimoto, Masanori Ikari, Edward Letts, entitled "REACTOR DESIGN FOR GROWING GROUP III NITRIDE CRYSTALS AND METHOD OF GROWING GROUP III NITRIDE CRYSTALS," attorneys docket number SIXPOI-004;

United States Utility Patent Application Serial No. 61/694,119, filed on August 28, 2012, by Tadao Hashimoto, Edward Letts, Sierra Hoff, entitled "GROUP III NITRIDE WAFER AND PRODUCTION METHOD," attorneys docket number SIXPOI-015;

United States Utility Patent Application Serial No. 61/705,540, filed on September 25, 2012, by Tadao Hashimoto, Edward Letts, Sierra Hoff, entitled "METHOD OF GROWING GROUP III NITRIDE CRYSTALS," attorneys docket number SIXPOI-014.

## BACKGROUND

Field of the invention.

The invention relates to a bulk crystal of semiconductor material used to produce semiconductor wafers for various devices including optoelectronic devices such as light emitting diodes (LEDs) and laser diodes (LDs), and electronic devices such as transistors. More specifically, the invention provides a bulk crystal of group III nitride such as gallium nitride. The invention also provides various methods of making these crystals.

Description of the existing technology

This document refers to several publications and patents as indicated with numbers within brackets, e.g., [x]. Following is a list of these publications and patents:

[1] R. Dwilinski, R. Doradzinski, J. Garczynski, L. Sierzputowski, Y. Kanbara, U.S. Patent No. 6,656,615.
[2] R. Dwilinski, R. Doradzinski, J. Garczynski, L. Sierzputowski, Y. Kanbara, U.S. Patent No. 7,132,730.
[3] R. Dwilinski, R. Doradzinski, J. Garczynski, L. Sierzputowski, Y. Kanbara, U.S. Patent No. 7,160,388.
[4] K. Fujito, T. Hashimoto, S. Nakamura, International Patent Application No. PCT/US2005/024239, WO07008198.
[5] T. Hashimoto, M. Saito, S. Nakamura, International Patent Application No. PCT/US2007/008743, WO07117689. See also US20070234946, U.S. Application Serial Number 11/784,339 filed April 6, 2007.
[6] D' Evelyn, U.S. Patent No. 7,078,731.

Gallium nitride (GaN) and its related group III nitride alloys are the key material for various optoelectronic and electronic devices such as LEDs, LDs, microwave power transistors, and solar-blind photo detectors. Currently LEDs are widely used in displays, indicators, general illuminations, and LDs are used in data storage disk drives. However, the majority of these devices are grown epitaxially on heterogeneous substrates, such as sapphire and silicon carbide because GaN substrates are extremely expensive compared to these heteroepitaxial substrates. The heteroepitaxial growth of group III nitride causes highly defected or even cracked films, which hinder the realization of high-end optical and electronic devices, such as high-brightness LEDs for general lighting or high-power microwave transistors.

To solve fundamental problems caused by heteroepitaxy, it is indispensable to utilize crystalline group III nitride wafers sliced from bulk group III nitride crystal ingots. For the majority of devices, crystalline GaN wafers are favorable because it is relatively easy to control the conductivity of the wafer and GaN wafer will provide the smallest lattice/thermal mismatch with device layers. However, due to the high melting point and high nitrogen vapor pressure at elevated temperature, it has been difficult to grow GaN crystal ingots. Currently, the majority of commercially available GaN substrates are produced by a method called hydride vapor phase epitaxy (HVPE). HVPE is a vapor phase method, which has difficulty in reducing dislocation density less than $10^5$ cm$^{-2}$.

To obtain high-quality GaN substrates for which dislocation density is less than $10^5$ cm$^{-2}$, a new method called ammonothermal growth has been developed [1-6]. Recently, high-quality GaN substrates having dislocation density less than $10^5$ cm$^{-2}$ can be obtained by ammonothermal growth. Since this ammonothermal method can produce a true bulk crystal, one can grow one or more thick crystals and slice them to produce GaN wafers. One or more dopants may also be incorporated during ammonothermal growth to affect donor concentration (i.e. electron concentration), acceptor concentration (i.e. hole concentration) or magnetic impurity concentrations (confer [1]). However, it is challenging to improve crystal quality, reduce crystal bowing and/or reduce cracking for bulk crystals which exceed approximately 1 mm in thickness.

WO 2011/044554 describes a large area nitride crystal, comprising gallium and nitrogen, with a non-polar or semi-polar large-area face, along with a method of manufacture. The crystal is said to be useful as a substrate for a light emitting diode, a laser diode, a transistor, a photodetector, a solar cell, or for photoelectrochemical water splitting for hydrogen generation.

WO 2010/017232 describes a method for large-scale manufacturing of gallium nitride boules. Large-area single crystal seed plates are suspended in a rack, placed in a large diameter autoclave or internally-heated high pressure apparatus along with ammonia and a mineralizer, and grown ammonothermally.

## SUMMARY OF THE INVENTION

The present invention provides a bulk crystal of group III nitride having a composition of $Ga_xAl_yIn_{1-x-y}N$ ($0 \leq x \leq 1$, $0 \leq x+y \leq 1$) and a thickness greater than 1 millimeter wherein the bulk crystal has at least three portions,

(a) a first portion comprising a seed crystal formed by hydride vapor phase epitaxy containing a dopant other than oxygen and having a first major face and a second major face, the first major face having an electron concentration, $N_{1seed}$, and the second major face having an electron concentration $N_{2seed}$,

(b) a second portion formed by ammonothermal growth on the first major face of the seed crystal and comprising a first crystalline region, wherein the first crystalline region has an electron concentration, $N_{1st\text{-}xtal}$,

(c) a third portion formed by ammonothermal growth on the second major face of the seed crystal and comprising a second crystalline region, wherein said second crystalline region has an electron concentration $N_{2nd\text{-}xtal}$, and

(d) wherein the electron concentration of the seed crystal, the first crystalline region, and the second crystalline region satisfy at least one of the following relationships:

$$0.1 < N_{1st\text{-}xtal} / N_{1seed} < 10 \text{ and/or } 0.1 < N_{2nd\text{-}xtal} / N_{2seed} < 10.$$

In one instance, the invention can provide a bulk crystal of group III nitride having a thickness of more than 1 mm with improved crystal quality, reduced lattice bowing and/or reduced crack density.

The seed crystal may be a composite crystal of said $Ga_xAl_yIn_{1-x-y}N$, wherein the composite crystal comprises a first seed crystal piece of said $Ga_xAl_yIn_{1-x-y}N$ and a separate, second seed crystal piece of said $Ga_xAl_yIn_{1-x-y}N$ affixed to a major face of the first seed crystal piece.

The present invention also provides a method of fabricating a bulk crystal of group III nitride comprising:

(a) providing a seed crystal of group III nitride formed by hydride vapor phase epitaxy, wherein the seed crystal has a dopant other than oxygen and a first major face having an electron concentration of $N_{1seed}$ and a second major face having an electron concentration of $N_{2seed}$;

(b) simultaneously growing a first crystalline portion of group III nitride on the first major face of the seed crystal and a second crystalline portion of group III nitride on the second major face of the second seed crystal by an ammonothermal method wherein group III nitride growth conditions are selected so that the electron concentration of the first crystalline portion ($N_{1st\text{-}xtal}$) and the electron concentration of the second crystalline portion ($N_{2nd\text{-}xtal}$) satisfy at least one of the following relationships:

$$0.1 < N_{1st\text{-}xtal} / N_{1seed} < 10 \text{ and/or } 0.1 < N_{2nd\text{-}xtal} / N_{2seed} < 10.$$

**BRIEF DESCRIPTION OF THE DRAWINGS**

Referring now to the drawings in which like reference numbers represent corresponding parts throughout:

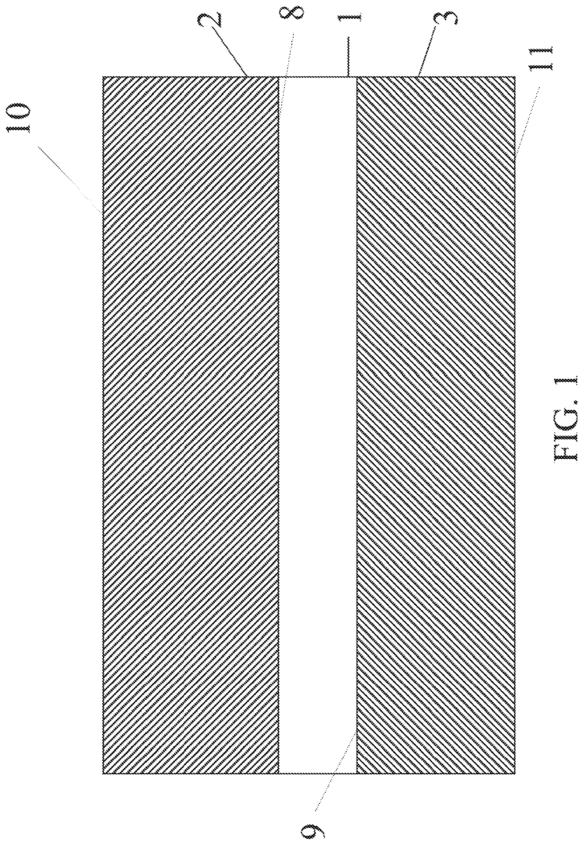

FIG. 1 is a schematic drawing of the bulk crystal of group III nitride.
In the figure each number represents the followings:

1. The first seed crystal
2. The first crystalline part grown on the first side of the first seed crystal
3. The second crystalline part grown on the second side of the first seed crystal
8. First major face of the seed crystal
9. Second major face of the seed crystal
10. First major face of the bulk crystal
11. Second major face of the bulk crystal

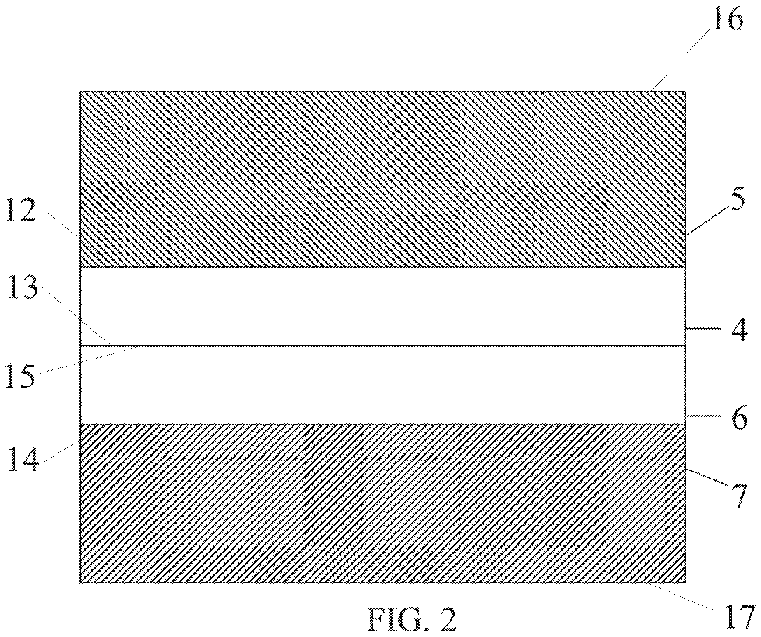

FIG. 2 is a schematic drawing of the bulk crystal of group III nitride.
In the figure each number represents the followings:

4. The first seed crystal
5. The first crystalline part grown on the first side of the first seed crystal
6. The second seed crystal
7. The second crystalline part grown on the first side of the second seed crystal

12. First major face of the first seed crystal

13. Second major face of the first seed crystal

14. First major face of the second seed crystal

15. Second major face of the second seed crystal

16. First major face of the bulk crystal

17. Second major face of the bulk crystal

Fig. 3 provides a flow diagram for a method described herein.

Fig. 4 provides a flow diagram for another method described herein.

## DETAILED DESCRIPTION OF THE INVENTION

### Overview

The bulk crystal of the present invention is typically sliced to produce group III nitride wafers suitable for fabricating various optoelectronic and electronic devices such as LEDs, LD, transistors, and photodetectors. Many optoelectronic and electronic devices are fabricated with thin films of group III nitride alloys (i.e. alloys of GaN, AlN and InN). Due to limited availability and high cost of single crystalline substrates of group III nitride, these devices have been fabricated on so-called heteroepitaxial substrates such as sapphire and silicon carbide. Since the heteroepitaxial substrates are chemically and physically different from the group III nitride, the device typically has a high density of dislocations ($10^8$~$10^{10}$ cm$^{-2}$) generated at the interface between the heteroepitaxial substrate and the device layer. Such dislocations deteriorate performance and reliability of devices, thus substrates composed of crystalline group III nitride such as GaN and AlN have been developed.

Currently, the majority of commercially available GaN substrates are produced with HVPE, in which it is difficult to reduce the dislocation density to less than $10^5$ cm$^{-2}$. Although the dislocation density of HVPE-GaN substrates is a few orders of magnitude lower than GaN film on heteroepitaxial substrates, the dislocation density is still a few orders of magnitude higher than typical silicon devices in electronics. To achieve higher device performance, lower dislocation density is required.

To attain dislocation density less than $10^5$ cm$^{-2}$, ammonothermal growth, which utilizes supercritical ammonia, has been developed. The ammonothermal method can produce GaN substrates with dislocation density less than $10^5$ cm$^{-2}$. One advantage of the ammonothermal method is that bulk crystals having a thickness greater than 1 mm can be grown. The ammonothermal method can also be used to grow crystals having various dopants such as donors (i.e. electron), acceptors (i.e. hole) or magnetic dopants. However, it is challenging to obtain a bulk crystal over 1 mm thick with improved crystal quality, reduced lattice curvature or reduced cracking. Although the origin and mechanism for poor characteristics of the bulk crystals are unknown, a possible cause would be stress accumulation inside the crystal due to a slight mismatch of thermal expansion coefficient or thermal conductivity caused by difference in electron concentration or oxygen concentration between the seed crystal and grown crystal.

### Technical Description of the Invention

In an effort to improve crystal quality, reduce lattice bowing, and/or reduce or eliminate cracking inside the bulk crystal of group III nitride having thickness greater than 1 mm, the current invention provides a method of making a bulk crystal of group III nitride in which one or more seed crystals have an electron concentration that matches the electron concentration of crystal grown on the seed crystals.

In conventional group III nitride growth processes, the electron concentration of the seed and/or electron concentration of new growth to be formed on a seed is not used as a factor in establishing group III nitride growth conditions in a reactor. In a conventional group III nitride growth process, a seed is first assessed to determine whether the seed has sufficient quality that new growth can be formed on it. Subsequently, conditions within a reactor are selected based on known growth process factors such as temperature, temperature difference, raw material concentration, and time to form new growth on the seed. The seed's properties such as electron concentration are not used in establishing conditions for new growth in conventional group III nitride processes. The seed is typically determined to be adequate for growth, and then the seed's properties are generally disregarded when selecting growth conditions for new material to be formed on the seed.

Many factors can affect electron concentration in new group III nitride growth on a seed. These factors include amount and type of dopant incorporated into new growth, the quality of the lattice that forms, operating conditions such as temperature in each reactor region, difference in these temperatures, mineralizer type and concentration, raw material concentration, and contaminant concentration.

We have learned that electron concentration in both the seed and new growth can be an important factor when forming new growth.

There are various ways of making the electron concentration in a seed formed in a first reaction sequence and new growth formed in a second, subsequent reaction sequence approximately the same.

In any of the methods above, the seed may be formed by a heteroepitaxial process if desired. For instance, the first reaction sequence used to form the seed may be hydride vapor phase epitaxy (HVPE) on sapphire substrate, the second reaction sequence used to form new growth on the seed being an ammonothermal process. Alternatively, in any of the methods above, the seed may be formed by a homoepitaxial process. Thus, the first reaction sequence may be HVPE deposition on a group III nitride substrate to form the seed, the second reaction sequence used to form new growth on the seed being an ammonothermal process.

A bulk crystal is provided in methods discussed above.

The bulk crystal has a seed having a first electron concentration and new growth having a second electron concentration, where the first electron concentration is about the same as the second electron concentration. In this case, electron concentration may or may not be adjusted with oxygen doping. A dopant such as silicon, carbon, germanium, sulfur, and/or selenium can be used in a sufficient amount to provide a seed with the desired first electron concentration and/or new growth having the second electron concentration.

Figure 1 presents one example of bulk crystal of this invention. The bulk crystal comprises the seed crystal 1 having electron concentration, $N_{seed}$; the first crystalline part 2 grown on the first side of the seed crystal 1 having electron concentration, $N_{1st\text{-}xtal}$; the optional second crystalline part 3 grown on the second side of the seed crystal 1 having electron concentration, $N_{2nd\text{-}xtal}$. The electron concentrations may have the following relationships:

$$0.1 < N_{1st\text{-}xtal} / N_{seed} < 10 \text{ and/or } 0.1 < N_{2nd\text{-}xtal} / N_{seed} < 10.$$

More preferably, the electron concentration has the following relationships:

$$0.5 < N_{1st\text{-}xtal} / N_{seed} < 5 \text{ and/or } 0.5 < N_{2nd\text{-}xtal} / N_{seed} < 5.$$

During the fabrication process of the bulk crystal, the bulk crystal experiences thermal and/or mechanical stress, which can cause crack formation. Although the detailed mechanism is still unknown, matching the electron concentration of seed and new growth can improve crystal quality, reduce lattice bowing and/or reduce crack formation in the bulk crystal.

In one instance, the bulk crystal may comprise four parts as shown in FIG. 2. The first crystalline part 5 is grown on the first side of the first seed crystal 4 and the second crystalline part 7 is grown on the first side of the second seed crystal 6. The first seed crystal 4 and second seed crystal 6 are attached together on the second side of each seed. The electron concentration of the first crystalline part 5, $N_{1st\text{-}xtal}$, the first seed crystal 4, $N_{1seed}$, the second seed crystal 6, $N_{2seed}$, the second crystalline part 7, $N_{2nd\text{-}xtal}$, have the following relationships:

$$0.1 < N_{1st\text{-}xtal} / N_{1seed} < 10 \text{ and/or } 0.1 < N_{2nd\text{-}xtal} / N_{2seed} < 10.$$

More preferably, the electron concentration have the following relationships:

$$0.5 < N_{1st\text{-}xtal} / N_{1seed} < 5 \text{ and/or } 0.5 < N_{2nd\text{-}xtal} / N_{2seed} < 5.$$

To fabricate the bulk crystal of group III nitride in this invention, ammonothermal growth is utilized because it allows simultaneous growth of crystalline material on both major faces of the seed crystal.

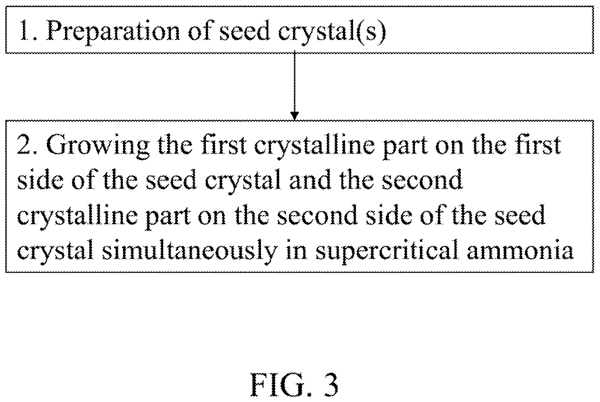

FIG. 3 shows a fabrication flow of bulk crystal having one seed crystal inside the bulk crystal. First, single crystalline seed crystals are prepared. The seed crystals are grown using HVPE. The seed crystals are grown with intentional doping of donors (e.g. silicon) to match the electron concentration.

By growing crystalline parts on both sides simultaneously, mechanical stress on both sides balances together, thus reducing crystal bowing caused by uneven stress applied to one side. The matching of electron concentration between seeds and grown parts is expected to reduce stress, thus to improve crystal quality, reduce lattice bowing or reduce cracking, during or after growth.

If the crystal is grown on both sides of one polar seed, the characteristics of the grown parts may vary depending on the polarity. In such case, the electron concentration of the seed crystal may be matched only to one side. For example, when bulk crystal of GaN is grown on a c-plane GaN seed, the crystal part grown on the N-polar side of the seed has better quality than that on the Ga-polar side. Thus, the electron concentration of the seed is matched only to N-side part of the crystal.

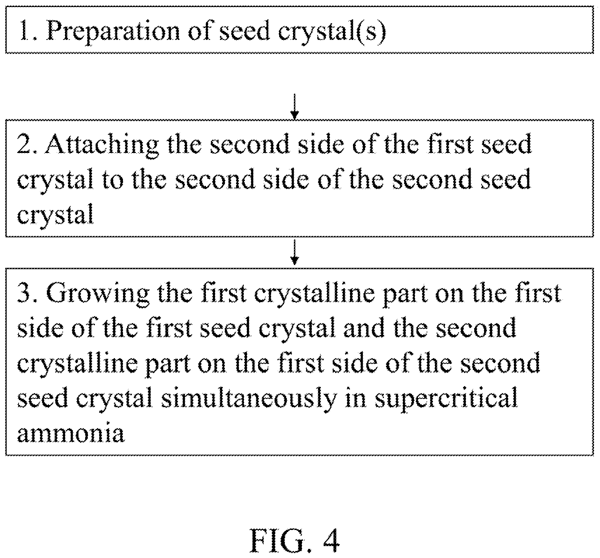

FIG. 4 shows a fabrication flow of bulk crystals having two seed crystals attached together to form a compound seed crystal. Single crystalline seed crystals are prepared in the similar manner as above. When polar (including semipolar) seed crystals, such as c-plane GaN or {11-21} GaN are used, characteristics of crystalline part grown on the seed depend on the polarity of the seed. To obtain similar characteristics on both sides of the seed, it is preferable to use two seed crystals attached together so that the same polar surfaces are exposed on both sides. For example, two c-plane GaN seed crystals are attached together on Ga face, and the composite seed crystal having N-polar faces on both sides can be used for ammonothermal growth.

By growing crystalline parts on both sides simultaneously, mechanical stress on both sides balances, thus reducing crystal bowing caused by uneven stress applied to one side. The matching of electron concentration between seeds and grown portions is expected to reduce stress, thus to improve crystal quality, reduce lattice bowing and/or reduce cracking during or after growth via stress reduction.

Reference Example 1 and Comparative Example

Following the process flow in FIG. 3, bulk crystals of GaN are grown simultaneously on two different seed crystals individually. One seed is used to form new growth having an electron concentration and/or an oxygen concentration that matches the expected value of the grown crystal. The other seed is used to form comparative new growth having an electron concentration or oxygen concentration mismatched to the expected value of the grown crystal to verify differences in the quality of new crystalline growth due to matching electron and/or oxygen concentration.

A single crystalline c-plane GaN seed crystal approximately 5 mm x 5 mm size with thickness of 463 microns was prepared by an ammonothermal growth process. The seed crystal was sliced from a bulk crystal of GaN grown in the ammonothermal method at about 550 °C in ammonia (50% fill to reactor volume) and sodium (4.5mol% to ammonia). With this growth condition, the electron concentration can typically be $2 \times 10^{19}$ cm$^{-3}$ and oxygen concentration can typically be $3 \times 10^{19}$ cm$^{-3}$. The full width half maximum (FWHM) of X-ray 002 peak measured on the N-side of this particular seed crystal was 906 arcsec and the curvature radius was 1.8 m (convex towards +c axis).

As a comparison, a single crystalline c-plane GaN seed crystal grown by HVPE in approximately 5 mm x 5 mm size was also prepared (HVPE-seed). The HVPE-made Si-doped GaN seed crystal can typically have an electron concentration of $1 \times 10^{18}$ cm$^{-3}$ and oxygen concentration of $5 \times 10^{16}$ cm$^{-3}$. The FWHM of X-ray 002 peak and lattice curvature radius measured on the N-side surface was 552 arcsec and -1.3 m (convex towards -c axis), respectively.

Then, new crystalline portions were grown on both Ga-polar side and N-polar side of each seed above simultaneously in supercritical ammonia. The growth temperature was about 550 °C, the ammonia fill factor was 50% and the sodium molar ratio to ammonia was 4.5%. Similar to the case for the ammonothermal seed, the expected carrier concentration and oxygen concentration of the grown crystalline parts are $2 \times 10^{19}$ cm$^{-3}$ and $3 \times 10^{19}$ cm$^{-3}$, respectively.

Since the growth condition for newly-deposited group III nitride is almost identical to that for the ammonothermal seed, the electron concentration and the oxygen concentration for the crystalline parts should essentially match those for the ammonothermal seed.

On the other hand, the calculated ratio of electron concentration of the crystalline part to that of the HVPE-seed is approximately 20, and the calculated ratio of oxygen concentration of the crystalline part to that of the HVPE-seed is approximately 600.

The total thickness of the bulk crystal grown on the ammonothermal seed was 1.3 mm and the X-ray FWHM from 002 diffraction obtained on the N-side crystalline part was reduced to 257 arcsec. This indicates that crystal quality was significantly improved after growth. The curvature radius on the N-side crystalline part increased from 1.8 m to 573m, which shows flattened crystal lattice. On the N-side of this crystal, no cracks were observed on 5 mm x 5 mm surface, thus the crack density was less than 4 cm$^{-2}$.

On the other hand for the comparative example, the total thickness of the bulk crystal grown on the HVPE-seed was 1.5 mm and the X-ray FWHM from 002 diffraction obtained on the N-side crystalline part was 580 arcsec. This shows that crystal quality was not improved. The curvature radius on the N-side crystalline part decreased from -1.3 m to 0.6 m, which indicates more curved lattice. The crystal exhibited several cracks over the 5 mm x 5 mm area, giving the crack density of greater than 10 cm$^{-2}$.

By matching the electron concentration and/or oxygen concentration of seed crystal to that of grown part, crystal quality, lattice curvature and crack density are improved. Lattice curvature can have an absolute value that exceeds 10 m, and crack density can be less than 10 cm$^{-2}$ when electron concentration and/or oxygen concentration of seed and new crystal growth are matched.

Electron concentration and/or oxygen concentration can be matched by selecting an appropriate seed crystal with similar oxygen and/or electron concentration, by adjusting amount of oxygen present during growth of group III nitride material on the seed crystal, and/or by adjusting amount of oxygen present during growth of the group III nitride seed crystal.

Reference Example 2

Following the process flow in FIG. 4, bulk crystals of GaN are grown simultaneously on both sides of seed crystals attached together on Ga face to form a compound seed. Single crystalline c-plane GaN seed crystals in approximately 10 mm x 25 mm size with thickness of 542 microns were prepared. The seed crystals were prepared by the ammonothermal method. The electron concentration is, based on previous data for similar seeds, approximately 1 x $10^{19}$ cm$^{-3}$ and oxygen concentration is, based on previous data for similar seeds, approximately 3 x $10^{19}$ cm$^{-3}$. The full width half maximum (FWHM) of X-ray 002 peak measured on the N-side was 287 arcsec and the curvature radius was -1.95 m (convex towards -c axis).

Two of the seed crystals were attached together on their Ga faces so that only N-polar faces were exposed on both sides. Then, crystalline parts were grown on both sides of the seeds simultaneously in supercritical ammonia. The growth temperature was about 520 °C, the ammonia fill factor was 55% and the sodium molar ratio to ammonia was 4.5%. The expected carrier concentration and oxygen concentration based on previous experiments are approximately 2 x $10^{19}$ cm$^{-3}$ and 3 x $10^{19}$ cm$^{-3}$, respectively. The ratio of electron concentration in the grown part to that of the seed is therefore calculated to be approximately 2, and the ratio of oxygen concentration in the grown part to that of the seed is therefore calculated to be approximately 1.

The total thickness of the bulk crystal grown on the seed was 4.8 mm and the X-ray FWHM from 002 diffraction obtained from one side of the crystal part was reduced to 99 arcsec. This indicates that crystal quality improves after growth. The curvature radius on the N-side crystal part increased from -1.95 m to 7.16 m, which shows flattened crystal lattice.

By matching the electron concentration or oxygen concentration of seed crystal to that of grown part, crystal quality and lattice curvature improve in this example. Electron concentration and/or oxygen concentration can be matched by selecting an appropriate seed crystal with similar oxygen and/or electron concentration, by adjusting amount of oxygen and/or dopant present during growth of group III nitride material on the seed crystal, and/or by adjusting amount of oxygen present during growth of the group III nitride seed crystal.

In other examples similar to those above, one or more dopants such as silicon, carbon, germanium, sulfur, and/or selenium are added during ammonothermal growth on ammonothermally-grown or HVPE-grown seeds in order to provide an electron concentration in new ammonothermal growth that is about the same as the electron concentration in the seed(s). Oxygen is optionally added along with the dopant(s). The seed may similarly have at least one of the dopants added during growth.

Advantages and Improvements

The bulk GaN crystal of this invention may have three parts: the first seed crystal, the first crystalline part grown on the first side of the first seed crystal and the second crystalline part grown on the second side of the first seed crystal. The electron concentration of the seed crystal is designed to match those of the grown parts.

The bulk crystal may comprise the following four parts; the first seed crystal, the first crystalline part grown on the first side of the first seed crystal, the second seed crystal, and the second crystalline part grown on the first side of the second seed crystal. In this case, the second side of the second seed crystal is attached to the second side of the first seed crystal, and the carrier concentration of the first crystalline part grown on the first side of the first seed matches with that of the first seed and the carrier concentration of the second crystalline part grown on the first side of the second seed matches with that of the second seed.

The matching of the electron concentration helps to improve crystal quality, reduce lattice bowing and reduce cracking.

The resulting improved-quality, reduced-bow, reduced-crack group III nitride crystals can be sliced to produce high-quality group III nitride wafers. Due to improved quality, improved bow, and reduced/eliminated cracks of the wafers, electronic/optoelectronic devices fabricated on such wafers can attain high performance.

Possible modifications

Although the preferred embodiment describes bulk crystals of GaN, similar benefit of this invention can be expected for other group III nitride alloys of various composition, such as AlN, AlGaN, InN, InGaN, or GaAlInN.

Although the preferred embodiment describes GaN seed crystal having thickness about 500 microns, similar benefit of this invention can be expected for other thicknesses between 100 microns to 2000 microns.

Although the preferred embodiment describes c-plane GaN seed crystals, similar benefit of this invention can be expected for other faces such as a-face, m-face, and various semipolar surfaces of group III nitride crystals. Also, the surface of the seed crystal can be slightly miscut (off-sliced) from these orientations.

**Claims**

1. A bulk crystal of group III nitride having a composition of $Ga_xAl_yIn_{1-x-y}N$ ($0 \leq x \leq 1$, $0 \leq x+y \leq 1$) and a thickness greater than 1 millimeter wherein the bulk crystal has at least three portions,

    (a) a first portion comprising a seed crystal formed by hydride vapor phase epitaxy containing a dopant other than oxygen and having a first major face and a second major face, the first major face having an electron concentration, $N_{1seed}$, and the second major face having an electron concentration $N_{2seed}$,
    (b) a second portion formed by ammonothermal growth on the first major face of the seed crystal and comprising a first crystalline region, wherein the first crystalline region has an electron concentration, $N_{1st\text{-}xtal}$,
    (c) a third portion formed by ammonothermal growth on the second major face of the seed crystal and comprising a second crystalline region, wherein said second crystalline region has an electron concentration $N_{2nd\text{-}xtal}$, and
    (d) wherein the electron concentration of the seed crystal, the first crystalline region, and the second crystalline region satisfy at least one of the following relationships:

$$0.1 < N_{1st\text{-}xtal} / N_{1seed} < 10 \text{ and/or } 0.1 < N_{2nd\text{-}xtal} / N_{2seed} < 10.$$

2. A bulk crystal according to claim 1 wherein the electron concentration of the seed crystal, the first crystalline region, and the second crystalline region satisfy at least one of the following relationships:

$$0.5 < N_{1st\text{-}xtal} / N_{1seed} < 5 \text{ and/or } 0.5 < N_{2nd\text{-}xtal} / N_{2seed} < 5.$$

3. A bulk crystal according to claim 1 or claim 2 wherein the seed crystal is a single crystal of said $Ga_xAl_yIn_{1-x-y}N$, the electron concentration of said first crystalline region satisfies at least one of said relationships, and the electron concentration of said second crystalline region does not satisfy at least one of said relationships.

4. A bulk crystal according to any of claims 1-3 wherein the first major face of the seed crystal is N-polar.

5. A bulk crystal according to claim 1 or claim 2 wherein the seed crystal is a composite crystal of said $Ga_xAl_yIn_{1-x-y}N$, and wherein the composite crystal comprises a first seed crystal piece of said $Ga_xAl_yIn_{1-x-y}N$ and a separate, second seed crystal piece of said $Ga_xAl_yIn_{1-x-y}N$ affixed to a major face of the first seed crystal piece.

6. A bulk crystal according to claim 5 wherein the electron concentration of the first crystalline region satisfies at least one of said relationships and wherein the electron concentration of the second crystalline region also satisfies at least one of said relationships.

7. A bulk crystal according to claim 5 or claim 6 wherein the first major face of the seed crystal is N-polar and the second major face of the seed crystal is N-polar.

8. A method of fabricating a bulk crystal of group III nitride comprising:

    (a) providing a seed crystal of group III nitride formed by hydride vapor phase epitaxy, wherein the seed crystal has

    a dopant other than oxygen and a first major face having an electron concentration of $N_{1seed}$ and a second major face having an electron concentration of $N_{2seed}$;

    (b) simultaneously growing a first crystalline portion of group III nitride on the first major face of the seed crystal and a second crystalline portion of group III nitride on the second major face of the second seed crystal by an ammonothermal method wherein group III nitride growth conditions are selected so that the electron concentration of the first crystalline portion ($N_{1st\text{-}xtal}$) and the electron concentration of the second crystalline portion ($N_{2nd\text{-}xtal}$) satisfy at least one of the following relationships:

$$0.1 < N_{1st\text{-}xtal} / N_{1seed} < 10 \text{ and/or } 0.1 < N_{2nd\text{-}xtal} / N_{2seed} < 10.$$

9. A method according to claim 8 wherein the reaction conditions are selected so that the electron concentration of the first crystalline portion ($N_{1st-xtal}$) and the electron concentration of the second crystalline portion ($N_{2nd-xtal}$) satisfy at least one of the following relationships:

$$0.5 < N_{1st\text{-}xtal} / N_{1seed} < 5 \text{ and/or } 0.5 < N_{2nd\text{-}xtal} / N_{2seed} < 5.$$

10. A method according to claim 8 or claim 9 wherein the seed crystal is a single crystal of said group III nitride and the operating conditions are selected so that the electron concentration of the first crystalline portion satisfies at least one of said relationships, and the electron concentration of the second crystalline portion does not satisfy at least one of said relationships.

11. A method according to claim 8 or claim 9 wherein the seed crystal is a single crystal of said group III nitride, and the operating conditions are selected so that the electron concentration of the first crystalline portion satisfies at least one of said relationships, and the electron concentration of the second crystalline portion additionally satisfies at least one of said relationships.

12. A method according to any of claims 8-11 wherein the first major face of the seed crystal is N-polar.

13. A method according to claim 8 or claim 9 wherein the seed crystal is a composite crystal comprising a first seed crystal piece of said group III nitride and a separate, second seed crystal piece of said group III nitride affixed to a major face of the first seed crystal piece.

14. A method according to claim 13 wherein the operating conditions are selected so that the electron concentration of the first crystalline portion satisfies at least one of said relationships and wherein the electron concentration of the second crystalline portion also satisfies at least one of said relationships.

15. A method according to claim 13 or claim 14 wherein the first major face and the second major face of the composite seed crystal are each N-polar faces.

16. A method according to any of claims 8-15 wherein the group III nitride is GaN.

17. A method according to any of claims 8-16 wherein the full width half maximum of the x-ray rocking curve from the bulk crystal is less than that of seed crystal.

18. A bulk crystal or method of any claim above in which the dopant is selected from silicon, carbon, germanium, sulfur, and selenium.

19. A bulk crystal or method of claim 18 wherein oxygen is also added along with the dopant.

**Patentansprüche**

1. Volumenkristall aus Gruppe III-Nitrid mit einer Zusammensetzung von $Ga_xAl_yIn_{1-x-y}N$ ($0{\leq}x{\leq}1$, $0{\leq}x+y{\leq}1$) und einer Stärke von mehr als 1 Millimeter, wobei der Volumenkristall mindestens drei Abschnitte aufweist,

(a) einen ersten Abschnitt, umfassend einen durch Hydrid-Dampfphasenepitaxie gebildeten Impfkristall, der einen anderen Dotierstoff als Sauerstoff enthält und eine erste Hauptfläche und eine zweite Hauptfläche aufweist, wobei die erste Hauptfläche eine Elektronenkonzentration $N_{1seed}$ aufweist und die zweite Hauptfläche eine Elektronenkonzentration $N_{2seed}$ aufweist,

(b) einen zweiten Abschnitt, der durch ammonothermisches Wachstum auf der ersten Hauptfläche des Impfkristalls gebildet wird und einen ersten kristallinen Bereich umfasst, wobei der erste kristalline Bereich eine Elektronenkonzentration $N_{1st-xtal}$ aufweist,

(c) einen dritten Abschnitt, der durch ammonothermisches Wachstum auf der zweiten Hauptfläche des Impfkristalls gebildet wird und einen zweiten kristallinen Bereich umfasst, wobei der zweite kristalline Bereich eine Elektronenkonzentration $N_{2nd-xtal}$ aufweist, und

(d) wobei die Elektronenkonzentration des Impfkristalls, des ersten kristallinen Bereichs und des zweiten kristallinen Bereichs mindestens eine der folgenden Beziehungen erfüllt:

$$0,1 < N_{1st\text{-}xtal} \,/\, N_{1seed} < 10 \text{ und/oder } 0,1 < N_{2nd\text{-}xtal} \,/\, N_{2seed} < 10.$$

2. Volumenkristall nach Anspruch 1, wobei die Elektronenkonzentration des Impfkristalls, des ersten kristallinen Bereichs und des zweiten kristallinen Bereichs mindestens eine der folgenden Beziehungen erfüllt:

$$0,5 < N_{1st\text{-}xtal} \,/\, N_{1seed} < 5 \text{ und/oder } 0,5 < N_{2nd\text{-}xtal} \,/\, N_{2seed} < 5.$$

3. Volumenkristall nach Anspruch 1 oder Anspruch 2, wobei der Impfkristall ein Einkristall von $Ga_xAl_yIn_{1\text{-}x\text{-}y}N$ ist, die Elektronenkonzentration des ersten kristallinen Bereichs mindestens eine der Beziehungen erfüllt und die Elektronenkonzentration des zweiten kristallinen Bereichs nicht mindestens eine der Beziehungen erfüllt.

4. Volumenkristall nach einem der Ansprüche 1-3, wobei die erste Hauptfläche des Impfkristalls N-polar ist.

5. Volumenkristall nach Anspruch 1 oder 2, wobei der Impfkristall ein Verbundkristall von $Ga_xAl_yIn_{1\text{-}x\text{-}y}N$ ist und wobei der Verbundkristall ein erstes Impfkristallstück von $Ga_xAl_yIn_{1\text{-}x\text{-}y}N$ und ein separates zweites Impfkristallstück von $Ga_xAl_yIn_{1\text{-}x\text{-}y}N$, das an einer Hauptfläche des ersten Impfkristallstücks fixiert ist, umfasst.

6. Volumenkristall nach Anspruch 5, wobei die Elektronenkonzentration des ersten kristallinen Bereichs mindestens eine der Beziehungen erfüllt und wobei die Elektronenkonzentration des zweiten kristallinen Bereichs auch mindestens eine der Beziehungen erfüllt.

7. Volumenkristall nach Anspruch 5 oder Anspruch 6, wobei die erste Hauptfläche des Impfkristalls N-polar ist und die zweite Hauptfläche des Impfkristalls N-polar ist.

8. Verfahren zur Herstellung eines Volumenkristalls aus Gruppe-III-Nitrid, umfassend:

   (a) Bereitstellen eines Impfkristalls aus Gruppe-III-Nitrid, der durch Hydrid-Dampfphasenepitaxie gebildet wird, wobei der Impfkristall Folgendes aufweist:

   einen anderen Dotierstoff als Sauerstoff und eine erste Hauptfläche mit einer Elektronenkonzentration von $N_{1seed}$ und
   eine zweite Hauptfläche mit einer Elektronenkonzentration von $N_{2seed}$;

   (b) gleichzeitiges Züchten eines ersten kristallinen Abschnitts von Gruppe-III-Nitrid auf der ersten Hauptfläche des Impfkristalls und eines zweiten kristallinen Abschnitts von Gruppe-III-Nitrid auf der zweiten Hauptfläche des zweiten Impfkristalls durch ein ammonothermisches Verfahren, wobei die Gruppe-III-Nitrid-Wachstumsbedingungen so gewählt werden, dass die Elektronenkonzentration des ersten kristallinen Abschnitts ($N_{ist\text{-}xtai}$) und die Elektronenkonzentration des zweiten kristallinen Abschnitts ($N_{2nd\text{-}xtal}$) mindestens eine der folgenden Beziehungen erfüllen:

$$0,1 < N_{1st\text{-}xtal} \,/\, N_{1seed} < 10 \text{ und/oder } 0,1 < N_{2nd\text{-}xtal} \,/\, N_{2seed} < 10.$$

9. Verfahren nach Anspruch 8, wobei die Reaktionsbedingungen so gewählt werden, dass die Elektronenkonzentration des ersten kristallinen Abschnitts ($N_{1st\text{-}xtal}$) und die Elektronenkonzentration des zweiten kristallinen Abschnitts ($N_{2nd\text{-}xtal}$) mindestens eine der folgenden Beziehungen erfüllen:

$$0,5 < N_{1st\text{-}xtal} \,/\, N_{1seed} < 5 \text{ und/oder } 0,5 < N_{2nd\text{-}xtal} \,/\, N_{2seed} < 5.$$

10. Verfahren nach Anspruch 8 oder 9, wobei der Impfkristall ein Einkristall des Gruppe-III-Nitrids ist und die Betriebsbedingungen so gewählt werden, dass die Elektronenkonzentration des ersten kristallinen Abschnitts mindestens eine der Beziehungen erfüllt und die Elektronenkonzentration des zweiten kristallinen Abschnitts nicht mindestens eine der Beziehungen erfüllt.

11. Verfahren nach Anspruch 8 oder 9, wobei der Impfkristall ein Einkristall des Gruppe-III-Nitrids ist und die Betriebsbedingungen so gewählt werden, dass die Elektronenkonzentration des ersten kristallinen Abschnitts mindestens eine der Beziehungen erfüllt und die Elektronenkonzentration des zweiten kristallinen Abschnitts zusätzlich mindestens eine der Beziehungen erfüllt.

12. Verfahren nach einem der Ansprüche 8-11, wobei die erste Hauptfläche des Impfkristalls Kristalls N-polar ist.

13. Verfahren nach Anspruch 8 oder 9, wobei der Impfkristall ein Verbundkristall ist, der ein erstes Impfkristallstück aus dem Gruppe III-Nitrid und ein separates zweites Impfkristallstück aus dem Gruppe III-Nitrid, das an einer Hauptfläche des ersten Impfkristallstücks befestigt ist, umfasst.

14. Verfahren nach Anspruch 13, wobei die Betriebsbedingungen so gewählt werden, dass die Elektronenkonzentration des ersten kristallinen Abschnitts mindestens eine der Beziehungen erfüllt und wobei die Elektronenkonzentration des zweiten kristallinen Abschnitts auch mindestens eine der Beziehungen erfüllt.

15. Verfahren nach Anspruch 13 oder Anspruch 14, wobei die erste Hauptfläche und die zweite Hauptfläche des Verbund-Impfkristalls jeweils N-polare Flächen sind.

16. Verfahren nach einem der Ansprüche 8 bis 15, wobei das Gruppe-III-Nitrid GaN ist.

17. Verfahren nach einem der Ansprüche 8-16, wobei die Halbwertsbreite der Röntgen-Rocking-Kurve von dem Volumenkristall kleiner ist als die des Impfkristalls.

18. Volumenkristall oder Verfahren nach einem der vorstehenden Ansprüche, wobei der Dotierstoff aus Silizium, Kohlenstoff, Germanium, Schwefel und Selen ausgewählt ist.

19. Volumenkristall oder Verfahren nach Anspruch 18, wobei zusammen mit dem Dotierstoff auch Sauerstoff hinzugefügt wird.

**Revendications**

1. Cristal massif de nitrure du groupe III ayant une composition de $Ga_xAl_yIn_{1-x-y}N$ ($0 \leq x \leq 1$, $0 \leq x+y \leq 1$) et une épaisseur supérieure à 1 millimètre dans lequel le cristal massif a au moins trois parties,

   (a) une première partie comprenant un germe cristallin formé par épitaxie en phase vapeur d'hydrure contenant un dopant autre que l'oxygène et ayant une première face principale et une deuxième face principale, la première face principale ayant une concentration en électrons, $N_{1seed}$, et la deuxième face principale ayant une concentration en électrons, $N_{2seed}$,
   (b) une deuxième partie formée par croissance ammonothermique sur la première face principale du germe cristallin et comprenant une première région cristalline, dans lequel la première région cristalline a une concentration en électrons, $N_{1st\text{-}xtal}$,
   (c) une troisième partie formée par croissance ammonothermique sur la deuxième face principale du germe cristallin et comprenant une deuxième région cristalline, dans lequel ladite deuxième région cristalline a une concentration en électrons $N_{2nd\text{-}xtal}$, et
   (d) dans lequel la concentration en électrons du germe cristallin, de la première région cristalline et de la deuxième région cristalline satisfont à au moins l'une des relations suivantes :

$$0,1 < N_{1st\text{-}xtal} / N_{1seed} < 10 \text{ et/ou } 0,1 < N_{2nd\text{-}xtal} / N_{2seed} < 10.$$

2. Cristal massif selon la revendication 1, dans lequel la concentration en électrons du germe cristallin, de la première région cristalline et de la deuxième région cristalline satisfont à au moins l'une des relations suivantes :

$$0,5 < N_{1st\text{-}xtal} / N_{1seed} < 5 \text{ et/ou } 0,5 < N_{2nd\text{-}xtal} / N_{2seed} < 5.$$

3. Cristal massif selon la revendication 1 ou 2, dans lequel le germe cristallin est un monocristal dudit $Ga_xAl_yIn_{1-x-y}N$, la concentration en électrons de ladite première région cristalline satisfait à au moins l'une desdites relations, et la concentration en électrons de ladite deuxième région cristalline ne satisfait pas à au moins l'une desdites relations.

4. Cristal massif selon l'une quelconque des revendications 1 à 3, dans lequel la première face principale du germe cristallin est N-polaire.

5. Cristal massif selon la revendication 1 ou la revendication 2, dans lequel le germe cristallin est un cristal composite dudit $Ga_xAl_yIn_{1-x-y}N$, et dans lequel le cristal composite comprend un premier fragment de germe cristallin dudit $Ga_xAl_yIn_{1-x-y}N$ et un deuxième fragment de germe cristallin séparé dudit $Ga_xAl_yIn_{1-x-y}N$ fixé sur une face principale du premier fragment de germe cristallin.

6. Cristal massif selon la revendication 5, dans lequel la concentration en électrons de la première région cristalline satisfait au moins à l'une desdites relations et dans lequel la concentration en électrons de la deuxième région cristalline satisfait également au moins à l'une desdites relations.

7. Cristal massif selon la revendication 5 ou 6, dans lequel la première face principale du germe cristallin est N-polaire et la deuxième face principale du germe cristallin est N-polaire.

8. Procédé de fabrication d'un cristal massif de nitrure du groupe III comprenant :

(a) la fourniture d'un germe cristallin de nitrure du groupe III formé par épitaxie en phase vapeur d'hydrure, dans lequel le germe cristallin a un dopant autre que l'oxygène et une première face principale ayant une concentration en électrons $N_{1seed}$ et une deuxième face principale ayant une concentration en électrons $N_{2seed}$ ;
(b) la croissance simultanée d'une première partie cristalline du nitrure du groupe III sur la première face principale du germe cristallin et d'une deuxième partie cristalline du nitrure du groupe III sur la deuxième face principale du deuxième germe cristallin par un procédé ammonotherme dans lequel les conditions de croissance du nitrure du groupe III sont choisies pour que la concentration en électrons de la première partie cristalline ($N_{1st-xtal}$) et la concentration en électrons de la deuxième partie cristalline ($N_{2nd-xtal}$) satisfont à au moins l'une des relations suivantes :

$$0,1 < N_{1st\text{-}xtal} / N_{1seed} < 10 \text{ et/ou } 0,1 < N_{2nd\text{-}xtal} / N_{2seed} < 10.$$

9. Procédé selon la revendication 8 dans lequel les conditions de réaction sont choisies pour que la concentration en électrons de la première partie cristalline ($N_{1st-xtal}$) et la concentration en électrons de la deuxième partie cristalline ($N_{2nd-xtal}$) satisfont à au moins l'une des relations suivantes :

$$0,5 < N_{1st\text{-}xtal} / N_{1seed} < 5 \text{ et/ou } 0,5 < N_{2nd\text{-}xtal} / N_{2seed} < 5.$$

10. Procédé selon la revendication 8 ou 9 dans lequel le germe cristallin est un monocristal dudit nitrure du groupe III et les conditions opératoires sont choisies pour que la concentration en électrons de la première partie cristalline satisfait à au moins l'une desdites relations, et la concentration en électrons de la deuxième partie cristalline ne satisfait pas à au moins l'une desdites relations.

11. Procédé selon la revendication 8 ou 9 dans lequel le germe cristallin est un monocristal dudit nitrure du groupe III, et les conditions opératoires sont choisies pour que la concentration en électrons de la première partie cristalline satisfait à au moins l'une desdites relations, et la concentration en électrons de la deuxième partie cristalline satisfait en outre à au moins l'une desdites relations.

12. Procédé selon l'une quelconque des revendications 8 à 11, dans lequel la première face principale du germe cristallin est N-polaire.

13. Procédé selon la revendication 8 ou 9, dans lequel le germe cristallin est un cristal composite comprenant un premier fragment de germe cristallin dudit nitrure du groupe III et un deuxième fragment de germe cristallin séparé dudit nitrure du groupe III fixé sur une face principale du premier fragment de germe cristallin.

14. Procédé selon la revendication 13 dans lequel les conditions opératoires sont choisies pour que la concentration en électrons de la première partie cristalline satisfait à au moins une desdites relations et dans lequel la concentration en électrons de la deuxième partie cristalline satisfait également à au moins une desdites relations.

15. Procédé selon la revendication 13 ou 14, dans lequel la première face principale et la deuxième face principale du germe cristallin composite sont chacune des faces N-polaires.

16. Procédé selon l'une quelconque des revendications 8 à 15, dans lequel le nitrure du groupe III est GaN.

17. Procédé selon l'une quelconque des revendications 8 à 16, dans lequel la moitié de largeur maximale de la courbe d'oscillation des rayons X provenant du cristal massif est inférieure à celle du germe cristallin.

18. Cristal massif ou procédé selon l'une quelconque des revendications ci-dessus, dans lequel le dopant est choisi parmi le silicium, le carbone, le germanium, le soufre et le sélénium.

19. Cristal massif ou procédé selon la revendication 18, dans lequel de l'oxygène est également ajouté avec le dopant.

FIG. 1

FIG. 2

EP 3 094 766 B1

1. Preparation of seed crystal(s)

2. Growing the first crystalline part on the first side of the seed crystal and the second crystalline part on the second side of the seed crystal simultaneously in supercritical ammonia

FIG. 3

| 1. Preparation of seed crystal(s) |
|---|

↓

| 2. Attaching the second side of the first seed crystal to the second side of the second seed crystal |
|---|

↓

| 3. Growing the first crystalline part on the first side of the first seed crystal and the second crystalline part on the first side of the second seed crystal simultaneously in supercritical ammonia |
|---|

FIG. 4

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 61928883
- US 2005024239 A, Kenji Fujito, Tadao Hashimoto and Shuji Nakamura
- US 78433907, Tadao Hashimoto, Makoto Saito, and Shuji Nakamura
- US 79031006, Tadao Hashimoto, Makoto Saito, and Shuji Nakamura
- US 97360207, Tadao Hashimoto and Shuji Nakamura
- US 97766107, Tadao Hashimoto
- US 61067117, Tadao Hashimoto, Edward Letts, Masanori Ikari
- US 61058900, Edward Letts, Tadao Hashimoto, Masanori Ikari
- US 61058910, Tadao Hashimoto, Edward Letts, Masanori Ikari
- US 61131917, Tadao Hashimoto, Masanori Ikari, Edward Letts
- US 61106110, Tadao Hashimoto, Masanori Ikari, Edward Letts
- US 61694119, Tadao Hashimoto, Edward Letts, Sierra Hoff
- US 61705540, Tadao Hashimoto, Edward Letts, Sierra Hoff
- US 6656615 B, R. Dwilinski, R. Doradzinski, J. Garczynski, L. Sierzputowski, Y. Kanbara
- US 7132730 B, R. Dwilinski, R. Doradzinski, J. Garczynski, L. Sierzputowski, Y. Kanbara
- US 7160388 B, R. Dwilinski, R. Doradzinski, J. Garczynski, L. Sierzputowski, Y. Kanbara
- US 2005024239 W, K. Fujito, T. Hashimoto, S. Nakamura
- WO 07008198 A
- US 2007008743 W, T. Hashimoto, M. Saito, S. Nakamura
- WO 07117689 A
- US 20070234946 A
- US 7078731 B, D' Evelyn
- WO 2011044554 A
- WO 2010017232 A